Europäisches Patentamt

(19) European Patent Office

Office européen des brevets

(11) Publication number: **0 193 992 B1**

# EUROPEAN PATENT SPECIFICATION

(45) Date of publication of patent specification: **21.11.91**

(21) Application number: **86200307.6**

(22) Date of filing: **28.02.86**

(51) Int. Cl.⁵: **H01L 21/82, H01L 21/28, H01L 29/78, H01L 29/08, H01L 21/31, H01L 21/00**

(54) Method of manufacturing an insulated gate field effect device.

(30) Priority: **04.03.85 US 708192**

(43) Date of publication of application:
**10.09.86 Bulletin 86/37**

(45) Publication of the grant of the patent:
**21.11.91 Bulletin 91/47**

(84) Designated Contracting States:
**DE FR GB NL**

(56) References cited:
| EP-A- 0 025 909 | EP-A- 0 098 652 |
| WO-A-84/04204 | FR-A- 2 293 796 |
| GB-A- 2 121 235 | US-A- 4 074 304 |

**IEEE TRANSACTIONS ON ELECTRON DE-VICES, vol. ED-29, no. 4, April 1982, pages 590-596, IEEE, New York, US; P.J. TSANG et al.: "Fabrication of high-performance LDDFET'S with oxide sidewall-spacer technology"**

(73) Proprietor: **N.V. Philips' Gloeilampenfabrieken Groenewoudseweg 1 NL-5621 BA Eindhoven(NL)**

(72) Inventor: **Chen, Teh-Yi James INT. OCTROOIBUREAU B.V. Prof. Holstlaan 6 NL-5656 AA Eindhoven(NL)**

(74) Representative: **Houbiers, Ernest Emile Marie Gerlach et al INTERNATIONAAL OCTROOIBUREAU B.V. Prof. Holstlaan 6 NL-5656 AA Eindhoven(NL)**

## Description

The present invention relates to a methods manufacturing an insulated gate field effect device comprising the steps of forming an electrically insulating layer of silicon oxide on the surface of a semiconductor region of a first conductivity type, depositing a doped polysilicon layer on said insulating layer, providing a patterned anti-oxidation masking layer on said polysilicon layer leaving a mask over at least the area in which the gate electrode is to he formed, diffusing the dopant from said polysiliconlayer through said insulating layer into said semiconductor region by thermal oxidation of said polysilicon layer where it is not covered by said mask thus forming source and drain regions of the second, opposite conductivity type on both sides of said mask, said diffusion being prevented where said oxidation has been prevented by said mask, the unoxidized portion of said polysilicon layer forming the gate electrode, and subsequently producing highly doped source and drain portions of the second conductivity type.

In field effect devices, such as an insulated gate field effect transistor (IGFET), it is desirable that the source and drain zones in the immediate proximity of the gate electrode have a lightly doped extension. This is particularly important in field effect devices having a very small channel length. The lightly doped extension in such devices increases the breakdown voltage of the drain gate junction and prevents the injection of hot charge carriers into the gate dielectric.

A method as described above is known from the article by Goto et al. "A new selfaligned source/drain diffusion technology from selectively oxidized polysilicon", IEDM 1979, p.585-588. In this prior art technique, prior to depositing the polysilicon layer source- and drain windows are etched in the insulating layer. Then, after depositing the polysilicon layer, the said masking layer is provided also above said window, and then the oxidation is carried out thus forming weakly doped and highly doped source and drain portions.

The method requires a masking step for forming the said windows as well as a rather critical positioning step to provide the masking layer exactly above the windows. Moreover the dopant of the highly doped source/drain portions cannot be chosen independently of the dopant of the weakly doped portions. These are disadvantages in very large scale integration where not only the number of positioning steps should he kept as low as possible in order to increase the reproducibility, but also the dopants should he chosen freely so as to he able to produce source- and drain regions of the required depth and doping concentration.

It is an object of the present invention to provide a highly reproducible method for manufacturing an insulated gate field effect transistor with very short lightly doped source and drain extensions, with a high degree of selfalignment.

According to the invention a method as described in the introductory part is characterized in that said thermal oxidation is continued so as to form laterally oxidized polysilicon portions under the edges of said mask, said diffusion producing lightly doped source- and drain extensions under said laterally oxidized portions, that the oxidized polysilicon and the underlying portions of said insulating layer are then etched away except for said laterally oxidized portions which are protected from the etching by said mask, thus exposing parts of said source and drain regions, after which ions are implanted into said exposed source- and drain region parts to produce said highly doped source and drain portions, said mask and said laterally oxidized portions shielding said lightly doped extensions during said ion implantation.

Other objects, features and advantages of the invention will he apparent from the following description and appended claims when considered in conjunction with the accompanying drawing in which:

Figure 1 is a cross-section of a device at an interim stage of its manufacture in accordance with the method of the invention;

Figure 2 is a cross-section of the device of Figure 1 at a later stage in its manufacture;

Figure 3 is a cross-section of the device of Figures 1 and 2 at a still later stage of its manufacture.

Figure 4 is a cross-section of the device of Figure 3 after one type of metallization; and

Figure 5 is a cross-section of the device of Figure 3 after another type of metallization.

The drawing is purely schematic and not to scale. This is particularly so with respect to the thicknesses of the elements of the device shown. Corresponding parts are designated by the same reference numerals in the various figures. Semiconductor regions of the same conductivity type are cross-hatched in the same direction.

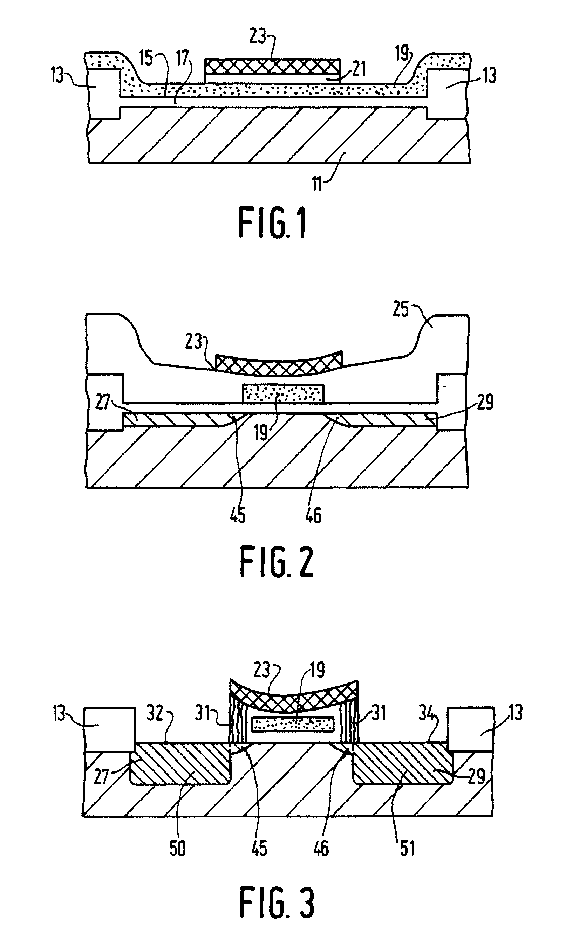

Figure 1 shows a device made in accordance with the method of the invention at an interim stage in the practice of the invention. The method starts with a semiconductor body 11 which in this case is chosen to be of p-type silicon. As will he apparent to those skilled in the art, however, the body could be of the n-type conductivity. An approximately one (1) micron (1 micron = 1 micrometre) thick layer 13 of silicon oxide surrounding part of the surface 15 is provided on body 11 by using any known method, for exampple, pyrolitic oxidation and etching, or local oxidation of silicon (LOCOS). Surface 15 of semiconductor body 11 is covered with an electrically insulating layer 17, also of silicon oxide, approximately 200 to 500 angstroms (1 angstrom = 0.1 nanometre) thick. This forms the gate oxide and is obtained, for example, by thermal oxidation. A polycrystalline silicon layer 19 between .15 and .25 microns thick is deposited on insulating layer 17 and on field oxide 13 in a typical manner such as by decomposition of a gaseous silicon compound. Polysilicon layer 19 is doped with an n-type dopant such as phosphorus, although other type dopants may also be used. Oxychloride phosphorus (POCl$_3$) is presently preferred as a doping source for this purpose. (If the method started with an n-type body obviously a p-type dopant, such as boron, would be used.)

In a manner well known in semiconductor technology, a .05 micron thick silicon oxide layer 21 may optionally be provided over layer 19. On top of this by means of low pressure chemical vapor deposition, a .08 to .2 micron thick silicon nitride layer 23 is provided. By way of photolithographic etching methods conventionally used in semiconductor technology, layers 21 and 23 are then given a certain pattern in which a layer of photolacquer (not shown) may be used as a mask. Phosphoric acid may be used as an etchant for the silicon nitride and a hydrofluoric acid containing solution may be used as an etchant for the silicon oxide. At that point in the method, a device such as shown in Figure 1 is obtained.

Polysilicon layer 19 is then oxidized by heat treating in an oxidizing atmosphere. This oxidizes the polysilicon to form the oxide layer 25. It also diffuses the n-type dopant from the polysilicon layer through insulating layer 17 into semiconductor body 11 on both sides of the mask formed by nitride layer 23 to form source and drain regions 27 and 29. By properly selecting the resistivity of semiconductor body 11, the oxidation temperature and time and the polysilicon thickness and resistivity, the desired junction depth of source and drain regions 27 and 29 and the lateral oxidation and diffusion under mask 23 is appropriately controlled. For thin gate oxides, for example, a high pressure polyoxidation at low temperatures such as 900°C can be used to prevent the formation of junctions that are too deep. This process of forming junctions through polysilicon oxidation is known and provides source and drain regions (27,29) with lightly doped extensions (45,46) as shown in Figure 2. By controlling the amount of lateral oxidation that takes place under mask 23 the size of gate electrode 19 can he predetermined.

After oxidation an anisotropic reactive ion etching is performed using the nitride layer 23 as a mask. During etching, the laterally oxidized sections or spacers 31 (Figure 3) are protected from etching by mask 23. As can be seen, insulating layer 17 not protected by mask 23 is also etched away to expose the upper surfaces 32 and 34 of source and drain regions 27 and 29. Arsenic is then ion implanted into the exposed source and drain regions to produce highly doped regions (50,51) of an n-plus type conductivity. As a result, source and drain regions are produced with n-type conductivity extensions (45,46) under spacers 31 and n+type conductivity regions in the prescribed contact areas. (If p-type source and drain regions are formed in an n-type body, a p+type conductivity dopant such as heron, would he used in the ion implantation step).

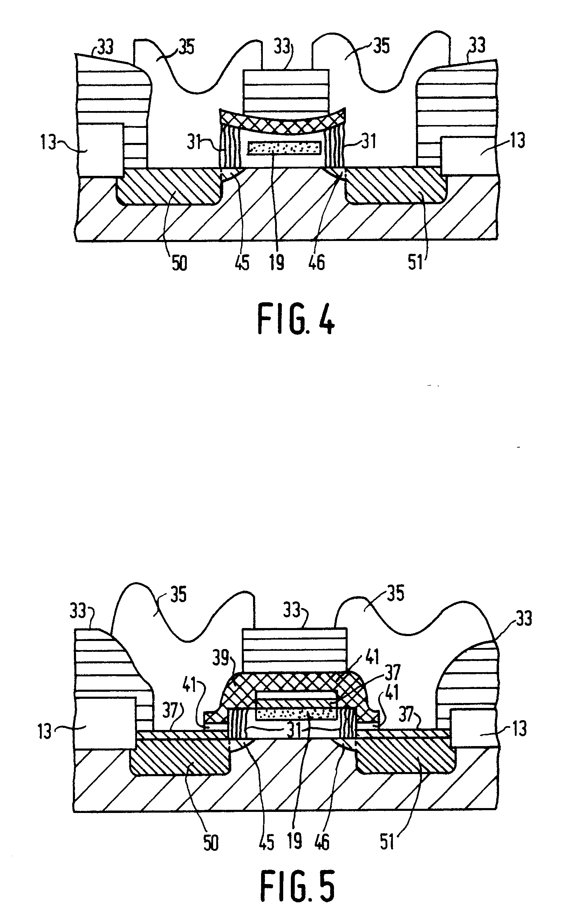

Phosphor silicate glass 33 is deposited on top of the entire device. Contact openings are etched in this glass by the use of oversized masks in any well known manner. Aluminium silicon 35 is then deposited in the contact openings to provide direct electrical contact to the source and drain regions. By using a photolithographic process to etch away the undesired aluminium, the device shown in Figure 4 is produced.

If it is desired to add a silicide layer before metallization, a device as that shown in Figure 5 is produced. Starting with the interim device of Figure 3, a thin oxide is grown on the contact areas 32 and 34 of the source and drain. The silicon nitride layer 23 is then etched away. The thin oxide on the source and drain contact areas 32 and 34 and the optional pad oxide 21 (Figure 1), if any, is also etched away. In the preferred embodiment, titanium is then deposited on the source and drain contact areas and on gate 19 to form the silicide layers 37 shown in Figure 5. A thin oxide 41 is then grown over the silicide. Silicon nitride 39 is then deposited on top of the thin oxide layer. With an oversized mask of photoresist, the silicon nitride and the thin oxide layer are both etched away to leave the patterned silicon nitride 39 as shown in Figure 5 and the oxide layers 41 as shown in the same figure. After this etching, phosphor silicate glass 33 is deposited on the device and etched to expose contact areas. Aluminium silicon contacts 35 are then deposited in any well known manner.

From the foregoing, it will be apparent to those skilled in the art that both NMOS, PMOS and CMOS devices can be fabricated from the disclosed self-aligned method.

It is understood that various modifications to the above-described method and device will became evident to those skilled in the art and that the arrangement described herein is for illustrative purposes and is not to he considered restrictive. In particular the body 11 may consist of a semiconductor material other than silicon.

**Claims**

1. A method of manufacturing an insulated gate field effect device comprising the steps of forming an electrically insulating layer (17) of silicon oxide on the surface of a semiconductor region (11) of a first conductivity type, depositing a doped polysilicon layer (19) on said insulating layer (17), providing a patterned anti-oxidation masking layer (23) on said polysilicon layer (19) leaving a mask (23) over at least the area in which a gate electrode is to be formed, diffusing the dopant from said polysilicon layer (19) through said insulating layer (17) into said semiconductor region (11) by thermal oxidation of said polysilicon layer (19) where it is not covered by said mask (23) thus forming source and drain regions (27,29) of the second , opposite conductivity type on both sides of said mask (23), said diffusion being prevented where said oxidation has been prevented by said mask (23), the unoxidized portion of said polysilicon layer (19) forming the gate electrode (19), and subsequently producing highly doped source and drain portions (50,51) of the second conductivity type, characterized in that said thermal oxidation is continued so as to form laterally oxidized polysilicon portions (31) under the edges of said mask (23), said diffusion producing lightly doped source- and drain extensions (45,46) under said laterally oxidized portions (31), that the oxidized polysilicon (25) and the underlying portions of said insulating layer (17) are then etched away except for said laterally oxidized portions (31) which are protected from the etching by said mask (23), thus exposing parts (32,34) of said source and drain regions (27,29), after which ions are implanted into said exposed source- and drain region parts (32,34) to produce said highly doped source and drain portions (50,51), said mask (23) and said laterally oxidized portions (31) shielding said lightly doped extensions (45,46) during said ion implantation.

2. A method as claimed in Claim 1, characterized in that said source and drain regions (27,29) are surrounded and delimited by a field oxide layer (13) which is thicker than said insulating layer (17).

3. A method as claimed in Claim 1 or Claim 2, characterized in that etching step is carried out by plasma-etching.

4. A method as claimed in any one of the preceding claims, characterized in that after said ion implantation step the masking layer (23) is etched away, after which a metal (35) is deposited on the exposed source and drain region parts (32,34) and on the gate electrode (19) and heated so as to form metal silicide layers (37) thereon.

5. A method as claimed in any one of the preceding claims characterized in that said masking layer (23) comprises silicon nitride.

6. A method as claimed in any one of the preceding claims characterized in that said polysilicon layer (19) is phosphorus-doped.

7. A method as claimed in any one of the preceding claims characterized in that said implantation is done with arsenic ions.

8. A method as claimed in any one of Claims 1 to 5 characterized in that said polysilicon layer (19) is boron-doped and that said implantation is done with boron ions.

**Revendications**

1. Procédé de fabrication d'un dispositif à effet de champ à grille isolée comportant les étapes constistant à former une couche électriquement isolante (17) en oxyde de silicium sur la surface d'une région semiconductrice (11) d'un premier type de conductivité, à déposer une couche en polysilicium dopé (19) sur ladite couche isolante (17), à réaliser une couche de masquage anti-oxydante configurée (23) sur ladite couche de polysilicium (19), à laisser subsister un masque (23) au moins sur la zone dans laquelle doit être formée une électrode de grille, à diffuser, à partir de ladite couche de polysilicium (19) et à travers ladite couche isolante (17), le dopant dans ladite région semiconductrice (11) par oxydation thermique de ladite couche de polysilicium (19) aux endroits où celle-ci n'est pas recouverte dudit masque (23), formant ainsi des régions de source et de drain (27, 29) du second type de conductivité opposé des deux côtés dudit masque (23), ladite diffusion étant évitée aux endroits où ladite oxydation a été évitée par ledit masque (23), la partie non oxydée de ladite couche de polysilicium (19) formant l'électrode de grille (19) et à créer ensuite des parties de source et de drain fortement dopées (50,51) du second type de conductivité, caractérisé en ce que ladite oxydation thermique est continuée de façon à former des parties de polysilicium latéralement oxydées (31) sous les bords dudit masque (23), ladite diffusion produisant des prolongements de source et de drain légèrement dopés (45,46) sous lesdites parties latéralement oxydées (31), en ce que le polysilicium oxydé (25) et les parties sous-jacentes de ladite couche isolante (17) sont alors enlevés par décapage, à l'exception desdites parties latéralement oxydées (31) qui sont protégées du décapage par ledit masque (23), de façon à mettre à découvert des parties (32,34) desdites régions de source et de drain (27,29), après quoi des ions sont implantés dans lesdites parties de région de source et de drain mises à découvert (32,34) pour créer lesdites parties de source et de drain fortement dopées (50,51), ledit masque (23) et lesdites parties latéralement oxydées (31) masquant lesdites prolongements légèrement dopés (45,46) durant ladite implantation d'ions.

2. Procédé selon la revendication 1, caractérisé en ce que lesdites régions de source et de drain (27,29) sont entourées et délimitées par une couche d'oxyde de champ (13) plus épaisse que ladite couche isolante (17).

3. Procédé selon la revendication 1 ou 2, caractérisé en ce que l'étape de décapage est effectuée par décapage par plasma.

4. Procédé selon l'une quelconque des revendications précédentes, caractérisé en ce qu'après ladite étape d'implantation d'ions, la couche de masquage (23) est enlevée par décapage, après quoi un métal (35) est déposé sur les parties de région de source et de drain (32, 34) mises à découvert et sur l'électrode de grille (19) et chauffé de façon à former des couches de siliciure de métal (37) sur celles-ci.

5. Procédé selon l'une quelconque des revendications précédentes, caractérisé en ce que ladite couche de masquage (23) comporte du nitrure de silicium.

6. Procédé selon l'une quelconque des revendications précédentes, caractérisé en ce que ladite couche de polysilicium (19) est dopée au phosphore.

7. Procédé selon l'une quelconque des revendications précédentes, caractérisé en ce que ladite implantation est effectuée par des ions d'arsenic.

8. Procédé selon l'une quelconque des revendications 1 à 5, caractérisé en ce que ladite couche de polysilicium (19) est dopée au bore et que ladite implantation est effectuée par des ions de bore.

**Patentansprüche**

1. Verfahren zum Herstellen einer Feldeffektanordnung mit isolierter GateElektrode, wobei die nachfolgenden Verfahrensschritte durchgeführt werden: das Bilden einer elektrisch isolierenden Schicht (17) aus Siliziumoxid auf der Oberfläche eine Halbleitergebietes (11) eines ersten Leitungstyps, das Niederschlagen einer dotierten Polysiliziumschicht (19) auf der genannten Isolierschicht (17), das Anbringen einer gemusterten Antioxidationsschicht (23) auf der genannten Polysiliziumschicht (19) unter Freilassung einer Maske (23) über wenigstens dasjenige Gebiet, in dem eine Gate-Elektrode gebildet werden soll, das Diffundieren des Dotierungsmittels aus der genannten Polysiliziumschicht (19) durch die genannte Isoliersticht (17) hindurch in das genannte Halbleitergebiet (11) hinein durch thermische Oxydation der genannten Polysiliziumschicht (19) an den Stellen, wo diese nicht durch die genannte Maske (23) bedeckt ist, wodurch auf diese Weise ein Source- und ein Drain-Gebiet (27, 29) vom zweiten, entgegengesetzten Leitungstyp gebildet werden und zwar auf beiden Seiten der genannten Maske (23), wobei dieses Diffundieren vermieden wird an den Stellen, wo die genannte Oxydation durch die genannte Maske (23) vermieden worden ist, wobei de nicht-oxidierte Teil der genannten Polysiliziumschicht (19) die Gate-Elektrode (19) bildet, und danach das Erzeugen eine hochdotierten Source- und Drain-Teils (50, 51) vom zweiten Leitungstyp, dadurch gekennzeichnet, daß die genannte thermische Oxydation fortgesetzt wird zum Bilden seitlich oxidierter Polysiliziumteile (31) unter den Rändern der genannten Maske (23), wobei diese Diffundierung leicht dotierte Source- und Drain-Fortsetzungen (45, 46) unterhalb der genannten seitlich oxidierten Teile (31) bildet, daß das oxidierte Polysilizium (25) und die darunter liegenden Teile der genannten Isolierschicht (17) danach weggeätzt werden mit Ausnahme der genannten seitlich oxidierten Teile (31), die durch die genannte Maske (23) gegen ätzen geschützt werden, wodurch auf diese Weise Teile (32, 34) des genannten Source- und Drain-Gebietes (27, 29) freigelegt werden, wonach in die genannten frei gelegten Source- und Drain-Gebiete (32, 34) Ionen implantiert werden zum Erzeugen der genannten hochdotierten Source- und Drain-Teile (50, 51), wobei die genannte Maske (23) und die genannten seitlich oxidierten Teile (31) die genannten leicht dotierten Fortsetzungen (45,46) während der genannten Ionenimplantation abschirmen.

2. Verfahren nach Anspruch 1, dadurch gekennzeichnet, daß das genannte Source- und Drain-Gebiet (27, 29) durch eine Feldoxidschicht (13), die dicker ist als die genannte Isolierschicht (17), umgehen und begrenzt sind.

3. Verfahren nach Anspruch 1 oder 2, dadurch gekennzeichnet, daß der Ätzvorgang durch Plasmaätzen erfolgt.

4. Verfahren nach einem der vorstehenden Ansprüche, dadurch gekennzeichnet, daß die Maskierungsschicht (23) nach der genannten Ionenimplantation weggeätzt wird, wonach auf den frei gelegten Source- und Draingebietsteilen (32, 34) und auf der Gate-Elektrode ein Metall (35) niedergeschlagen und erhitzt wird, damit darauf eine Metallsilizidschicht (37) gebildet wird.

5. Verfahren nach einem der vorstehenden Ansprüche, dadurch gekennzeichnet, daß die genannte Maskierungsschicht (23) Siliziumnitrid aufweist.

6. Verfahren nach einem der vorstehenden Ansprüche, dadurch gekennzeichnet, daß die genannte Polysiliziumschicht (19) phosphordotiert ist.

7. Verfahren nach einem der vorstehenden Ansprüche, dadurch gekennzeichnet, daß die genannte Implantation mit Arsenionen durchgeführt wird.

8. Verfahren nach einem der Ansprüche 1 bis 5, dadurch gekennzeichnet, daß die genannte Polysiliziumschicht (19) bordotiert ist und dal die genannte Implantation mit Borionen durchgeführt wird.

FIG.1

FIG.2

FIG.3

7

33    35    33    35    33

13    31    31    13

50    45  19  46    51

## FIG. 4

35    35

33    33    33

39    41

41    37

13    37    41    37    13

31

50    45  19  46    51

## FIG. 5